(19) Europäisches Patentamt

European Patent Office

Office européen des brevets

(11) **EP 1 184 976 B1**

(12) **EUROPEAN PATENT SPECIFICATION**

(45) Date of publication and mention
of the grant of the patent:
**18.05.2005 Bulletin 2005/20**

(51) Int Cl.$^7$: **H03G 3/34**

(21) Application number: **00117539.7**

(22) Date of filing: **14.08.2000**

(54) **Noise peak detection in AM reception**

Rauschspitzenwertermittlung im AM-Empfang

Détection de crête de bruit dans la réception en AM

(84) Designated Contracting States:
**DE ES FR GB IT**

(43) Date of publication of application:
**06.03.2002 Bulletin 2002/10**

(73) Proprietor: **Sony International (Europe) GmbH
10785 Berlin (DE)**

(72) Inventors:
• **Nöthlings, Rolf, Advanced Technology Center
70327 Stuttgart (DE)**
• **Wildhagen, Jens, Advanced Technology Center
70327 Stuttgart (DE)**

(74) Representative: **Müller - Hoffmann & Partner
Patentanwälte,
Innere Wiener Strasse 17
81667 München (DE)**

(56) References cited:
**EP-A- 0 526 662          US-A- 4 462 048
US-A- 5 583 891**

**Description**

The present invention relates to the noise peak detection in AM reception, in particular to a noise peak detection circuit for AM reception and to a method to generate a noise peak indication signal within a noise peak detection circuit arranged in the signal flow of an AM receiver.

Generally, in AM broadcasting signals are often disturbed by impulsive noises which can e. g. be caused by other technical devices located more or less close to the receiver. A common way of treating such "clicks" is to detect noise peaks and to use a noise blanker to suppress them.

A noise blanker receives a noise peak indication signal depending on which a sample of the AM signal is passed through or suppressed. The sample of the AM signal usually has been processed by a certain number of processing stages within the AM receiver before the noise peak is detected and suppressed, e.g. this detection and suppression is performed in the baseband. Alternatively to the mere suppression, the last clear sample, i.e. the last sample without noise pulse, can be repeated.

The main difficulty of this technique is to reliably judge whether the input signal of the noise detector generating said noise indication signal, which input signal is usually a partly processed received AM signal, comprises a disturbing noise component.

Therefore, it is the object underlying the present invention to provide a reliable method for noise peak detection in AM reception.

This problem is solved by a noise peak detection circuit for AM reception according to independent claim 1 and a method to generate a noise peak indication signal within a noise peak detection circuit arranged in the signal flow of an AM receiver according to independent claim 11. Preferred embodiments thereof are respectively defined in the following dependent claims.

According to the present invention an orthogonal component of an input signal is determined which orthogonal component has an orthogonal relation to an information component of the input signal, wherein said noise peak detection circuit generates a noise peak indication signal on basis of said detected orthogonal component.

Therewith, the present invention performs the noise peak detection independently from the information part of the input signal, which input signal is usually a partly processed received AM signal, since only the component of the input signal which is orthogonal to the information part of the input signal is considered to determine whether a noise peak is present in the input signal or not.

Further, the present invention is applicable to coherent and to incoherent AM reception. In case of coherent AM reception simply the q-component of the input signal might be observed which does not comprise any amplitude in case no noise is present. In case of incoherent AM reception the tangential component of the complex pointer rotating in the complex plane might be observed.

Preferably, according to the present invention the noise peak detection circuit within an AM receiver generates and outputs a noise peak indication signal derived by a noise peak detection within an input signal on basis of an actual angular change of a complex signal corresponding to said input signal.

Therewith, a complex signal usually needed during AM demodulation and retrieval of the transmitted information signal, e. g. the complex baseband signal of a transmitted audio signal, is used to derive the noise peak indication signal which indicates whether the currently supplied signal comprises a noise peak or not. In particular, according to the present invention the angular change of the actually supplied complex signal is determined to derive said noise peak indication signal rather than the amplitude, i.e. the information part, of the complex pointer which is used according to the prior art.

Further preferably, said actual angular change is determined by an angle increment determination unit on basis of an actual sample of the complex signal and at least one preceding sample thereof. Advantageously, two directly succeeding samples are used so that the actual angular change is determined by subtracting the angle of the preceding sample from that of the actual sample. This is the frequency demodulation of the AM signal. In this way the minimum storage capacity will be needed to determine the actual angular change.

Still further preferably, a usual angular change compensating unit calculates an angular change irregularity by considering the usual angular change caused by the frequency offset of said complex signal within said actual angular change. Therewith, according to this preferred embodiment of the present invention the usual rotation of the complex vector of the AM signal is considered within said actual angular change, i. e. a variation of the actual angular change to an expected angular change is used to determine said noise peak indication signal. Advantageously, the angular change irregularity is derived by subtracting the usual angular change from the actual angular change, but it is also possible to consider the usual angular change during a threshold comparison of the actual angular change or a signal derived therefrom to evaluate the content of the noise peak indication signal.

These considerations are also applicable to coherent and incoherent AM reception, since in case of coherent reception the q-component directly indicates the angular change irregularity.

Still further preferably, the absolute value of the angular change irregularity is determined. In this case a following threshold comparison to decide whether the angular change irregularity indicates a considerable noise peak needs less calculation power.

Still further preferably, an influence of a preferrably non-linear weighted magnitude of said complex signal on the noise peak indication signal is introduced by a scaling unit which might include a look-up table. Advantageously, the (absolute) angular change irregularity is multiplied with said magnitude of said complex signal, but it is also possible to consider this magnitude within a following threshold comparison to determine the content of the noise peak indication signal. Further advantageously, the actual sample of the complex signal is used to calculate the magnitude used for scaling. The scaling of the (absolute) angular change irregularity by the current magnitude of the signal makes the noise indication signal independent of the current signal amplitude.

Further preferably, an influence of a level of an output signal of the AM receiver on the noise peak indication signal is introduced by a weighting unit. Advantageously, such a weighting is performed on the eventually scaled (absolute) angular change irregularity, but alternatively the level of the output signal of the AM receiver can also be considered during a following threshold comparison to generate the content of the noise peak indication signal. With this weighting it is considered that noise appearing during loud signals is less disturbing than noise appearing in low signals, in particular, since the used noise blanker might generate audible distortions depending on the signal amplitude.

Further preferably, said level of the output signal is calculated on basis of a weighted envelope of an information part of the input signal. Therewith, only the content and no disturbances are considered for the weighting. To allow a variation on the influence of this information part of the signal the envelope thereof can preferably be weighted variably.

Further preferably, the generating of the noise peak indication signal includes a threshold comparison, i. e. the processed actual angular change is compared against a threshold and in case it lies above the threshold the noise peak indication signal indicates a considerable noise peak which should be eliminated whereas otherwise no noise peak processing has to be performed on the actual sample of the input signal.

Still further preferably, the actual sample of the magnitude of the complex signal is output in case no noise peak is detected whereas otherwise the last undisturbed sample of the magnitude of the complex signal is output to perform the noise peak processing. This is a very easy way of blanking the noise peak without generating a silent gap in the output signal. Of course, any other signal within the AM path can be subjected to this blanking instead. Also, other methods to blank the noise peak can be performed instead by an appropriate signal processing of the input signal, e.g. the blanking of only those parts of the frequency spectrum of the actual sample which are disturbed.

Further features and advantages of the AM receiver and the method to detect noise peaks within the input signal of a noise peak detection circuit arranged in the signal flow of an AM receiver according to the present invention will be elucidated by the following detailed description of an exemplary embodiment thereof taken in conjunction with the accompanying drawings, wherein

**Fig. 1** shows a block diagram of a noise peak detection and blanking part of an AM receiver according to a preferred embodiment of the present invention,

**Fig. 2** shows a complex signal corresponding to an input signal which is usually a processed received AM signal without disturbances, and

**Fig. 3** shows the complex signals shown in Fig. 2 in case of a noise peak.

Generally, in the AM envelope demodulation the input signal s(t) is gained by using the absolute value of the complex baseband signal, i. e. the received AM signal which has been amplified, down-converted into the baseband and splitted into inphase and inquadrature components. In complex notation the input signal s (t) can be expressed by the following formula:

$$s(t) = |[1 + m \cdot v(t)] \cdot e^{j \cdot \Delta\omega \cdot t}|$$

wherein m is the modulation index, v(t) represents the information within the input signal, and $\Delta\omega$ is a carrier frequency offset. Therewith, the transmitted information is contained in the absolute value of a complex phaser which is rotating with a frequency of $\Delta\omega$ in the complex plain.

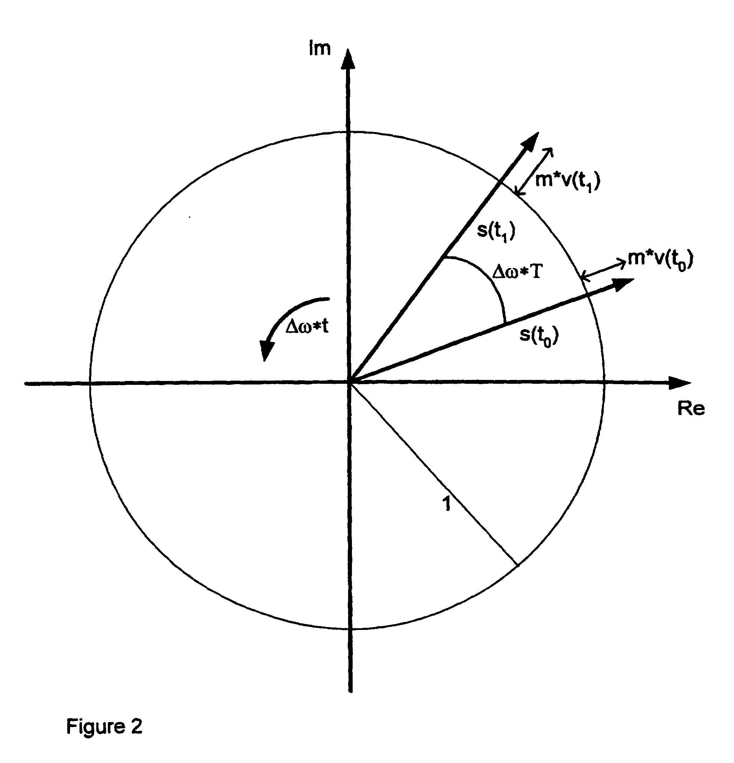

Fig. 2 shows two samples of this complex phaser in the complex plain, namely a first sample $s(t_0)$ taken at time $t_0$ which comprises a signal part $m \cdot v(t_0)$ of the signal vector exceeding a circle with radius 1 around the zero point of the complex plain and which is therewith equal to the information part of the signal. Further, a second sample $s(t_1)$ of the information signal taken at time $t_1 = t_0 + T$ is shown which comprises the information part $m \cdot v(t_1)$. Since the complex pointer of the information signal rotates with frequency $\Delta\omega$ in the complex plain the angle inbetween the first and the second sample of the information signal, i. e. inbetween $s(t_0)$ and $s(t_1)$ corresponds to $\Delta\omega \cdot T$. This is the frequency demodulation of the AM signal.

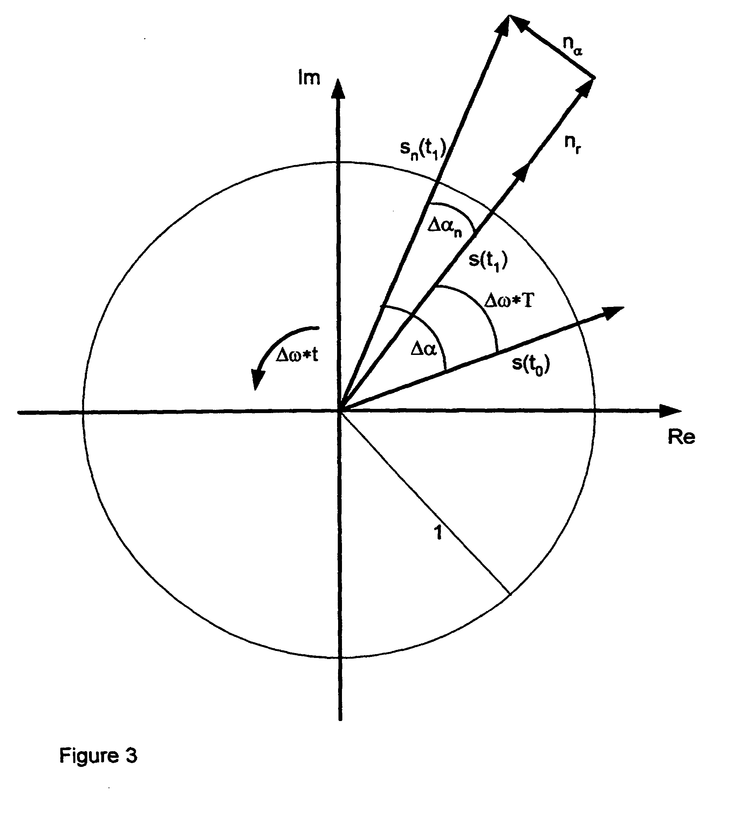

According to the present invention the angle of the complex pointer is analyzed to generate an indicator for noise pulses. Fig. 3 shows the two samples of the information signal shown in Fig. 2, but in this case the second sample $s(t_1)$ is disturbed by a noise pulse with a signal vector n comprising a radial noise component $n_r$ and a tangential noise component $n_\alpha$ in respect to the circle of unity, which signal vector n is added to the second sample $s(t_1)$ to result in a disturbed second sample

$s_n(t_1)$. Therefore, according to the present invention the noise component $n_\alpha$ vertical to the radial component $n_r$ and changing the angle of the signal vector is used to determine whether a sample of the information signal $s(t)$ comprises a noise pulse. This method is in particular applicable to incoherent AM signals, since without noise the change of the angle inbetween succeeding signal vectors is only dependent on the time period T between two samples of the information signal.

As mentioned above, with coherent AM signals only the q-component has to be observed, since in this case the information part equals to the i-component and the q-component deviates from zero in case of a noise pulse.

Therewith, according to the present invention the angle of the complex baseband signal is watched and if there is a difference in the current angle increment $\Delta\alpha$, i.e. the angle increment between the actual and the directly preceding samples, from the usual angle increment $\Delta\omega \cdot T$ caused by the frequency offset, this difference $\Delta\alpha_n = \Delta\alpha - \Delta\omega \cdot T$ is supposed to be caused by noise. The noise $n_\alpha$ itself is then estimated by

$$n_\alpha \approx \Delta\alpha_n \cdot s_n(t_1).$$

If $n_\alpha$ exceeds a preset threshold a noise peak is detected. The scaling of $\Delta\alpha_n$ by the current magnitude of the signal makes the noise indication independent of the current signal amplitude. To avoid problems caused by heavy noise disturbing low amplitudes (see FM-threshold effect) a preferrably non-linear weighting can be introduced. This might be realized with a look-up table.

As mentioned above, the resulting vector $s_n(t1)$ of the input signal at time $t_1 = t_0 + T$ is built by adding the noise components $n_r$ and $n_\alpha$ to the signal vector $s(t_1)$. Therewith, the resulting signal vector $s_n(t1)$ is rotated in respect to the signal vector $s(t_0)$ of the preceding sample by $\Delta\alpha = \Delta\omega \cdot T + \Delta\alpha_n$.

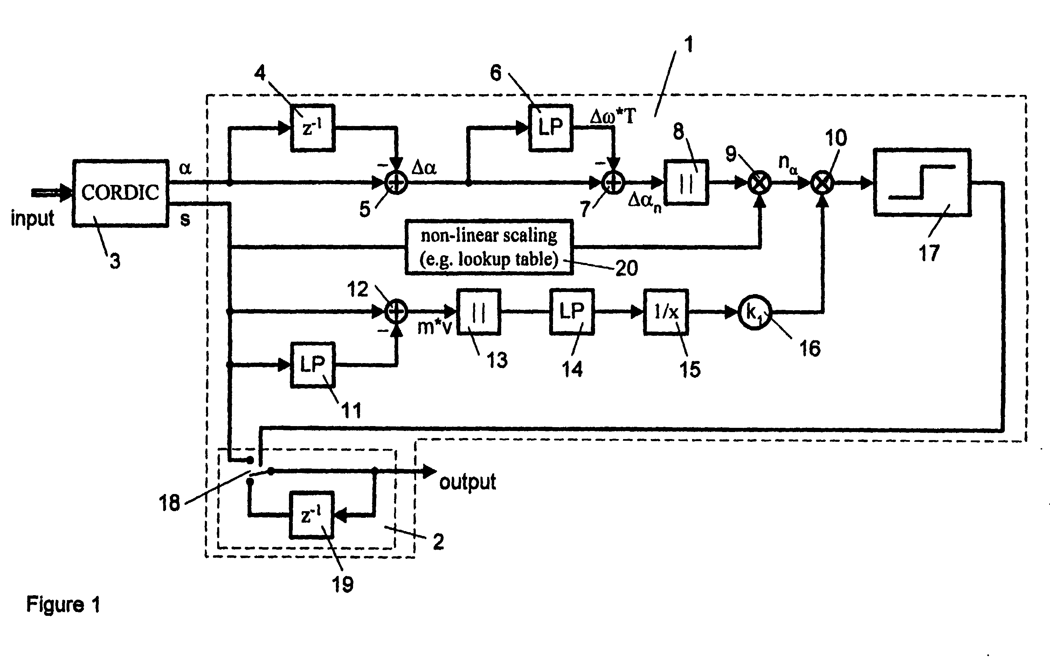

Fig. 1 shows a possible realization of a noise peak detector 1 including a blanker 2 according to a preferred embodiment of the present invention. Fig. 1 shows a noise peak detection curcuit 1 receiving the absolute value s and the angle $\alpha$ of the complex baseband signal vector which serves as an input signal from a CORDIC calculation unit 3. The noise peak detection circuit 1 generates a noise peak indication signal and outputs the last undisturbed absolute value s received from the CORDIC calculation unit 3 via a noise blanker 2. In case the noise detection circuit 1 does not detect that an incoming sample of the absolute value s and the angle a of the complex baseband signal vector includes a noise peak the generated noise peak indication signal switches a switch 18 within the noise blanker 2 so that the absolute value s input thereto is output by the noise blanker 2. Otherwise, the switch 18 gets switched so that the output signal of a delay element 19 included within the noise blanker 2 gets output by the noise blanker 2, which delay element 19 has a delay of one sample clock period T and receives the output signal of the noise blanker 2 as its input signal. Therewith, the noise blanker 2 outputs always the last clear sample, i. e. the last sample without a noise peak. Of course, the noise blanker 2 can also operate on the input signal of the CORDIC calculation unit 3 or any other signal within the AM path, i.e. any other signal derived from the received AM signal.

Since the absolute angle of the current input vector is determined by the CORDIC calculation unit 3 within the noise peak detection circuit 1 first the angle increment $\Delta\alpha$ is evaluated by subtracting the previous angle $\alpha_n$ from the current angle $\alpha_{n-1}$. Therefore, the angle $\alpha_n$ output from the CORDIC calculation unit 3 is input into a one sample period T delay element 4 and as minuent to a first subtractor 5 which receives the output signal of the one sampling period delay element 4 as subtrahent.

The output signal of the first subtractor 5, i. e. the actual angle increment $\Delta\alpha$ is input as minuent to a second subtractor 7 and to a first lowpass filter 6 which outputs the usual angle increment $\Delta\omega \cdot T$ caused by the frequency offset as subtrahent to the second subtractor 7. This second subtractor 7 outputs the indicator for noise pulses, namely the angular change irregularity $\Delta\alpha_n$.

The angular change irregularity $\Delta\alpha_n$ is inputted into a first absolute value determination unit 8 which output signal gets scaled by the magnitude of the current signal vector $s_n(t_1)$ to make the noise indication independent of the current signal amplitude by a first multiplier 9. The magnitude of the current signal vector $s_n(t_1)$ might be subjected to a non-linear scaling as described above by way of a look-up table 20 or another appropriate weighting calculation unit before being supplied to the first multiplier 9.

As noise appearing during loud signals is less disturbing than noise appearing in low signals the output signal of the first multiplier 9 gets further weighted by the envelope of $m \cdot v(t)$, which is the information part of the input signal $s(t)$ by a second multiplier 10 before a comparator 17 performs a threshold comparison on the output signal of the second multiplier 10 to determine the noise peak indication signal, e. g. a signal "0" in case the output signal of the second multiplier 10 lies below the selected threshold and a signal "1" if said output signal exceeds the selected threshold.

The weighting signal supplied to the second multiplier 10 is calculated by first calculating the signal amplitude which is the difference inbetween the amplitude and a DC part of the information signal which is lowpass filtered itself to obtain the envelope. Therefore, the absolute value s of the complex baseband signal output by the CORDIC calculation unit 3 is input as minuent to a third subtractor 12 which receives the absolute value s of the complex baseband signal vector which is lowpass filtered by a lowpass filter 11 as subtrahent. The output signal of the third subtractor 12 is input to a second absolute value determination unit 13 before it is input into a third lowpass filter 14 which derives the envelope signal. Since noise is less disturbing in loud signals the blanking should be inverse proportional to this envelope signal. Therefore, the envelope signal is supplied to a 1/X calculation unit 15 before finally, a weighting with factor $k_1$ is applied in a weighting unit 16 to vary the influence of the derived envelope signal on the threshold decision 17. This 1/X calculation unit 15 may limit its calculated result to avoid a misleading result in case X is very small. This limiter functionality may be realized by a non-linear look-up table.

Of course, the order of scaling or weighting can be altered or the scaling and/or weighting can be included into the threshold decision instead. It is also possible to consider the usual angle increment $\Delta\omega \cdot T$ which is caused by the frequency offset within the threshold comparison 17.

In case the angle a and the absolute value s of the complex baseband signal vector are determined by the CORDIC algorithm it might be necessary to consider over-modulation which means that the signal $|m \cdot v(t)|$ becomes bigger than one. The consequence is that the angle increment becomes $\pi +/-(\Delta\alpha)$ and the angle will exceed the threshold most probably, i. e. these effects are blanked most probably as well. If no blanking shall be caused by over-modulation these effects need to be observed additionally.

**Claims**

1. Noise peak detection circuit (1) for AM reception, **characterized by** an orthogonal component detector (4, 5) determining an orthogonal component ($n_\alpha$) of an input signal which orthogonal component ($n_\alpha$) has an orthogonal relation to an information component ($m \cdot v(t_1)$) of the input signal, wherein said noise peak detection circuit (1) generates a noise peak indication signal on basis of said detected orthogonal component ($n_\alpha$).

2. Noise peak detection circuit (1) according to claim 1, **characterized in that** an actual angular change ($\Delta\alpha$) of a complex signal ($s_n(t_1)$) corresponding to said input signal gets detected to represent said orthogonal component ($n_\alpha$).

3. Noise peak detection circuit (1) according to claim 2, **characterized in that** said orthogonal component detector (4, 5) determines said actual angular change ($\Delta\alpha$) on basis of an actual sample of the complex signal ($s_n(t_1)$) and at least one preceding sample of the complex signal ($s(t_0)$).

4. Noise peak detection circuit (1) according to claim 2 or 3, **characterized by** an usual angular change compensating unit (6, 7) calculating an angular change irregularity ($\Delta\alpha_n$) by considering the usual angular change ($\Delta\omega \cdot T$) of said complex signal ($s_n(t_1)$) within said actual angular change ($\Delta\alpha$).

5. Noise peak detection circuit (1) according to claim 4, **characterized by** a first absolut value determining unit (8) to determine the absolute value of said angular change irregularity ($\Delta\alpha_n$).

6. Noise peak detection circuit (1) according to anyone of claims 2 to 5, **characterized by** a scaling unit (9) introducing an influence of a preferably non-linear weighted magnitude (s) of said complex signal ($s_n(t_1)$) on the noise peak indication signal.

7. Noise peak detection circuit (1) according to anyone of claims 1 to 6, **characterized by** a weighting unit (10 - 16) introducing an influence of a level of the information component ($m \cdot v(t_1)$) on the noise peak indication signal.

8. Noise peak detection circuit (1) according to claim 7, **characterized in that** said level of the information component ($m \cdot v(t_1)$) is calculated on basis of a weighted envelope thereof.

9. Noise peak detection circuit (1) according to anyone of claims 1 to 8, **characterized by** a comparator (17) determining said noise peak indication signal on basis of a threshold comparison.

10. Noise peak detection circuit (1) according to anyone of claims 1 to 9, **characterized by** a noise blanker (2), comprising a switch (18) outputting an actual sample of the magnitude (s) of said complex signal ($s(t_0)$) in case the noise peak indication signal indicates that no noise peak is detected and the last undisturbed sample of the information component magnitude (s) of said complex signal ($s(t_0)$) in case the noise peak indication signal indicates that a noise peak is detected, and a storage unit (19) to store said last undisturbed sample of the magnitude (s) of said complex signal ($s(t_0)$).

11. Method generate a noise peak indication signal within a noise peak detection circuit (1) arranged in the signal flow of an AM receiver, **characterized by** the step of determining an orthogonal component ($n_\alpha$) of an input signal of said noise peak detection circuit (1) which orthogonal component ($n_\alpha$) has an orthogonal relation to an information component ($m \cdot v(t)$) of the input signal.

12. Method according to claim 11, **characterized in that** said orthogonal component ($n_\alpha$) corresponds to an actual angular change ($\Delta\alpha$) of a complex sig-

nal ($s_n(t_1)$) corresponding to said input signal.

13. Method according to claim 12, **characterized in that** said actual angular change ($\Delta\alpha$) is determined on basis of an actual sample of the complex signal ($s_n(t_1)$) and at least one preceding sample of the complex signal ($s(t_0)$).

14. Method according to claim 12 or 13, **characterized by** a calculation of an angular change irregularity ($\Delta\alpha_n$) by considering a usual angular change ($\Delta\omega \cdot T$) of said complex signal ($s_n(t_1)$) within said actual angular change ($\Delta\alpha$).

15. Method according to claim 14, **characterized by** a determination of the absolute value of said angular change irregularity ($\Delta\alpha_n$).

16. Method according to anyone of claims 12 to 15, **characterized by** a consideration of a magnitude ($s$) of said complex signal ($s_n(t_1)$).

17. Method according to anyone of claims 11 to 16, **characterized by** a consideration of a level of said information component ($m \cdot v(t_1)$).

18. Method according to claim 17, **characterized in that** said level of the information component ($m \cdot v(t_1)$) is determined on basis of a weighted envelope thereof.

19. Method according to anyone of claims 11 to 18, **characterized by** a threshold comparison.

20. Method according to anyone of claims 11 to 19, **characterized by** outputting an actual sample of the the magnitude ($s$) of said complex signal ($s(t_0)$) in case the noise peak indication signal indicates that no noise peak is detected and the last undisturbed sample of the the magnitude ($s$) of said complex signal ($s(t_0)$) in case the noise peak indication signal indicates that a noise peak is detected.

**Patentansprüche**

1. Rauschspitzen-Detektor-Schaltung (1) für AM-Empfang, **gekennzeichnet durch** einen Detektor für orthogonale Komponenten (4,5) zum Ermitteln einer orthogonalen Komponente ($n_\alpha$) eines Eingangssignals, dessen orthogonale Komponente ($n_\alpha$) einen orthogonalen Bezug zu einer Informationskomponente ($m \cdot v(t_1)$) des Eingangssignals hat, wobei die Rauschspitzen-Detektor-Schaltung (1) ein auf der ermittelten orthogonalen Komponente ($n_\alpha$) basierendes Rauschspitzenwert-Hinweissignal erzeugt.

2. Rauschspitzen-Detektor-Schaltung (1) gemäß Anspruch 1, **dadurch gekennzeichnet, dass** eine gegenwärtige Winkeländerung ($\Delta\alpha$) eines dem Eingangssignal entsprechenden komplexen Signals ($s_n(t_1)$) zur Bildung der orthogonalen Komponente ($n_\alpha$) ermittelt wird.

3. Rauschspitzen-Detektor-Schaltung ( 1 ) gemäß Anspruch 2, **dadurch gekennzeichnet, dass** der Detektor für orthogonale Komponenten (4, 5) die gegenwärtige Winkeländerung ($\Delta\alpha$) basierend auf einem gegenwärtigen Muster des komplexen Signals ($s_n(t_1)$) und wenigstens einem vorangehenden Muster des komplexen Signals ($s(t_0)$) bestimmt.

4. Rauschspitzen-Detektor-Schaltung (1) gemäß Anspruch 2 oder 3, **gekennzeichnet durch** eine übliche Winkeländerungskompensationseinheit (6,7) zum Berechnen einer Winkeländerungsabweichung ($\Delta\alpha_n$) **durch** Berücksichtigen der gewöhnlichen Winkeländerung ($\Delta\omega \cdot T$) des komplexen Signals ($s_n(t_1)$) im Rahmen der gegenwärtigen Winkeländerung ($\Delta\alpha$).

5. Rauschspitzen-Detektor-Schaltung (1) gemäß Anspruch 4, **gekennzeichnet durch** eine erste Absolutwertbestimmungseinheit (8) zum Bestimmen des Absolutwerts der Winkeländerungsabweichung ($\Delta\alpha_n$).

6. Rauschspitzen-Detektor-Schaltung (1) gemäß einem der Ansprüche 2 bis 5, **gekennzeichnet durch** eine Skalierungseinheit (9) zum Einführen einer Beeinflussung des Rauschspitzenwert-Hinweissignals **durch** eine vorzugsweise nicht linear gewichtete Größe ($s$) des komplexen Signals ($s_n(t_1)$).

7. Rauschspitzen-Detektor-Schaltung (1) gemäß einem der Ansprüche 1 bis 6, **gekennzeichnet durch** eine Gewichtungseinheit (10-16) zum Einführen einer Beeinflussung des Rauschspitzenwert-Hinweissignals **durch** einen Pegel der Informationskomponente ($m \cdot v(t_1)$).

8. Rauschspitzen-Detektor-Schaltung (1) gemäß Anspruch 7, **dadurch gekennzeichnet, dass** der Pegel der Informationskomponente ($m \cdot v(t_1)$) basierend auf einer darauf gewichteten Einhüllenden berechnet wird.

9. Rauschspitzen-Detektor-Schaltung (1) gemäß einem der Ansprüche 1 bis 8, **gekennzeichnet durch** einen Komparator (17) zum Bestimmen des Rauschspitzenwert-Hinweissignals basierend auf einem Schwellwertvergleich.

10. Rauschspitzen-Detektor-Schaltung (1) gemäß einem der Ansprüche 1 bis 9, **gekennzeichnet durch** einen Störaustaster (2) mit einem Schalter (18) zum Ausgeben eines gegenwärtigen Musters der Größe (s) des komplexen Signals ($s(t_0)$) im Falle, dass das Rauschspitzenwert-Hinweissignal angibt, dass kein Rauschspitzenwert ermittelt wurde und zum Ausgeben des letzten ungestörten Musters der Größe (s) der Informationskomponente des komplexen Signals ($s(t_0)$) im Falle, dass das Rauschspitzenwert-Hinweissignal angibt, dass ein Rauschspitzenwert ermittelt wurde, und **durch** eine Speichereinheit (19) zum Speichern des letzten ungestörten Musters der Größe (s) des komplexen Signals ($s(t_0)$).

11. Verfahren zum Erzeugen eines Rauschspitzenwert-Hinweissignals in einer Rauschspitzen-Detektor-Schaltung (1), die in den Signalablauf eines AM-Empfängers eingebunden ist, **gekennzeichnet durch** den Schritt zum Ermitteln einer orthogonalen Komponente ($n_\alpha$) eines Eingangssingnäls der Rauschspitzen-Detektor-Schaltung (1), dessen orthogonale Komponente (n ) in orthogonaler Beziehung zu einer Informationskomponente ($m \cdot v(t)$) des Eingangssignals steht.

12. Verfahren nach Anspruch 11, **dadurch gekennzeichnet, dass** die orthogonale Komponente ($n_\alpha$) einer gegenwärtigen Winkeländerung ($\Delta\alpha$) eines dem Eingangssignal entsprechenden komplexen Signals ($s_n(t_1)$) entspricht.

13. Verfahren gemäß Anspruch 12, **dadurch gekennzeichnet, dass** die gegenwärtige Winkeländerung ($\Delta\alpha$) basierend auf einem gegenwärtigen Muster des komplexen Signals ($s_n(t_1)$) und wenigstens einem vorhergehenden Muster des komplexen Signals ($s(t_0)$) ermittelt wird.

14. Verfahren nach Anspruch 12 oder 13, **gekennzeichnet durch** eine Berechnung einer Winkeländerungsabweichung ($\Delta\alpha_n$) unter Berücksichtigung einer gewöhnlichen Winkeländerung ($\Delta\omega \cdot T$) des komplexen Signals ($s_n(t_1)$) im Rahmen der gegenwärtigen Winkeländerung ($\Delta\alpha$).

15. Verfahren nach Anspruch 14, **gekennzeichnet durch** eine Ermittlung des Absolutwerts der Winkeländerungsabweichung ($\Delta\alpha_n$).

16. Verfahren nach einem der Ansprüche 12 bis 15, **gekennzeichnet durch** eine Berücksichtigung einer Größe (s) des komplexen Signals ($s_n(t_1)$).

17. Verfahren nach einem der Ansprüche 11 bis 16, **gekennzeichnet durch** eine Berücksichtigung eines Pegel der Informationskomponente ($m \cdot v(t_1)$)

18. Verfahren nach Anspruch 17, **dadurch gekenn-**

**zeichnet, dass** der Pegel der Informationskomponente ($m \cdot v(t_1)$) basierend auf einer hierauf gewichteten Einhüllenden ermittelt wird.

19. Verfahren nach einem der Ansprüche 11 bis 18, **gekennzeichnet durch** einen Schwellwertvergleich.

20. Verfahren nach einem der Ansprüche 11 bis 19, **gekennzeichnet durch** Ausgeben eines gegenwärtigen Musters der Größe (s) des komplexen Signals ($s(t_0)$) im Falle, dass das Rauschspitzenwert-Hinweissignal angibt, dass kein Rauschspitzenwert ermittelt wurde und Ausgeben des letzten ungestörten Musters der Größe (s) des komplexen Signals ($s(t_0)$) im Falle, dass das Rauschspitzenwert-Hinweissignal angibt, dass ein Rauschspitzenwert ermittelt wurde.

**Revendications**

1. Détecteur de pic de bruit (1) pour une réception AM, **caractérisé par** un détecteur de composante orthogonale (4,5) déterminant une composante orthogonale ($n_\alpha$) d'un signal d'entrée, laquelle composante orthogonale ($n_\alpha$) possède une relation orthogonale par rapport à une composante d'information ($m.v(t_1)$) du signal d'entrée, ledit circuit de détection de pic de bruit (1) produisant un signal d'indication de pic de bruit sur la base de ladite composante orthogonale détectée ($n_\alpha$).

2. Circuit de détection de pic de bruit (1) selon la revendication 1, **caractérisé en ce qu'**une variation angulaire effective ($\Delta\alpha$) d'un signal complexe ($s_n(t_1)$) correspondant audit signal d'entrée est détectée de manière à représenter ladite composante orthogonale ($n_\alpha$).

3. Circuit de détection de pic de bruit (1) selon la revendication 2, **caractérisé en ce que** ledit détecteur de composante orthogonale (4,5) détermine ladite variation angulaire effective ($\Delta\alpha$) sur la base d'un échantillon réel du signal complexe ($s_n(t_1)$) et d'au moins un échantillon précédent du signal complexe ($s(t_0)$).

4. Circuit de détection de pic de bruit (1) selon la revendication 2 ou 3, **caractérisé par** un unité (6,7) de compensation de variation angulaire usuelle calculant une irrégularité de variation angulaire ($\Delta\alpha_n$) en considérant la variation angulaire usuelle ($\Delta\omega.T$) dudit signal complexe ($s_n(t_1)$) dans ladite variation angulaire réelle ($\Delta\alpha$).

5. Circuit de détection de pic de bruit (1) selon la revendication 4, **caractérisé par** une première unité (8) de détermination de valeur absolue servant à déterminer la valeur absolue de ladite irrégularité de variation angulaire ($\Delta\alpha_n$).

6. Circuit de détection de pic de bruit (1) selon l'une quelconque des revendications 2 à 5, **caractérisé par** une unité de cadrage d'échelle (9) introduisant une influence d'une amplitude non linéaire pondérée (s) dudit signal complexe ($s_n(t_1)$) sur le signal d'indication de pic de bruit.

7. Circuit de détection de pic de bruit (1) selon l'une quelconque des revendications 1 à 6, **caractérisé par** une unité de pondération (10-16) introduisant une influence d'un niveau de la composante d'information ($m.v(t_1)$) sur le signal d'indication de pic de bruit.

8. Circuit de détection de pic de bruit (1) selon la revendication 7, **caractérisé en ce que** ledit niveau de la composante d'information ($m.v(t_1)$) est calculé sur la base d'une enveloppe pondérée de cette composante.

9. Circuit de détection de pic de bruit (1) selon l'une quelconque des revendications 1 à 8, **caractérisé par** un comparateur (17) déterminant ledit signal d'indication de pic de bruit sur la base d'une comparaison à un seuil.

10. Circuit de détection de pic de bruit (1) selon l'une quelconque des revendications 1 à 9, **caractérisé par** un suppresseur de bruit (2), comprenant un commutateur (18) délivrant un échantillon réel de l'amplitude (s) dudit signal complexe ($s(t_0)$) dans le cas où le signal d'indication de pic de bruit indique qu'aucun pic de bruit n'est détecté et que le dernier échantillon non perturbé de l'amplitude (s) de la composante d'information dudit signal complexe ($s(t_0)$) dans le cas où le signal d'indication de pic de bruit indique qu'un pic de bruit est détecté, et une unité de mémoire (19) pour mémoriser ledit dernier échantillon non perturbé de l'amplitude (s) dudit signal complexe ($s(t_0)$).

11. Procédé pour générer un signal d'indication de pic de bruit dans un circuit de détection de pic de bruit (1) disposé dans le flux de signaux d'un récepteur AM, **caractérisé par** l'étape consistant à déterminer une composante orthogonale ($n_\alpha$) d'un signal d'entrée dudit circuit de détection de pic de bruit (1), laquelle composante orthogonale ($n_\alpha$) possède une relation orthogonale avec une composante d'information ($m.v(t)$) du signal d'entrée.

12. Procédé selon la revendication 11, **caractérisé en ce que** ladite composante orthogonale ($n_\alpha$) correspond à une variation angulaire réelle ($\Delta\alpha$) d'un signal complexe ($s_n(t_1)$) correspondant audit signal

d'entrée.

13. Procédé selon la revendication 12, **caractérisé en ce que** ladite variation angulaire réelle ($\Delta\alpha$) est déterminée sur la base d'un échantillon réel du signal complexe ($s_n(t_1)$) et d'au moins un échantillon précédent du signal complexe ($s(t_0)$).

14. Procédé selon la revendication 12 ou 13, **caractérisé par** un calcul d'une irrégularité de variation angulaire ($\Delta\alpha_n$) en considérant une variation angulaire usuelle ($\Delta\omega.T$) dudit signal complexe ($s_n(t_1)$) dans ladite variation angulaire réelle ($\Delta\alpha$).

15. Procédé selon la revendication 14, **caractérisé par** une détermination de la valeur absolue de ladite irrégularité de variation angulaire ($\Delta\alpha_n$).

16. Procédé selon l'une quelconque des revendications 12 à 15, **caractérisé par** la prise en compte d'une amplitude (s) dudit signal complexe ($s_n(t_1)$).

17. Procédé selon l'une quelconque des revendications 11 à 16, **caractérisé par** la prise en compte d'un niveau de ladite composante d'information ($m.v(t_1)$).

18. Procédé selon la revendication 17, **caractérisé en ce que** ledit niveau de la composante d'information ($m.v(t_1)$) est déterminée sur la base d'une enveloppe pondérée de cette composante.

19. Procédé selon l'une quelconque des revendications 1 à 18, **caractérisé par** une comparaison à un seuil.

20. Procédé selon l'une quelconque des revendications 11 à 19, **caractérisé par** la délivrance d'un échantillon réel de l'amplitude (s) dudit signal complexe ($s(t_0)$) dans le cas où le signal d'indication de pic de bruit indique qu'aucun pic de bruit n'est détecté, et le dernier échantillon non perturbé de l'amplitude (s) dudit signal complexe ($s(t_0)$) dans le cas où le signal d'indication de pic de bruit indique qu'un pic de bruit est détecté.

Figure 1

Figure 2

Figure 3